# EUROPEAN PATENT APPLICATION

(11) **EP 4 761 528 A1**
(43) Date of publication of application: **17.06.2026**
(21) Application number: 25206055.3
(22) Date of filing: 01.10.2025
(51) Int. Cl.: H10H 20/819, H10H 20/855, H10H 20/831, H10H 20/84, H10H 20/841, H10H 29/24

(54) **MICRO-LED WITH IMPROVED LIGHT EXTRACTION EFFICIENCY**

(30) Priority: 10.12.2024 US 202418974798
(71) Applicant: Meta Platforms Technologies, LLC, Menlo Park, CA 94025 (US)
(72) Inventor: Mezouari, Samir, Menlo Park (US); Breakspear, Robert Leslie, Menlo Park (US)
(74) Representative: Murgitroyd & Company

(57) **Abstract**

A micro-LED includes a mesa structure and a tapered dielectric waveguide. The mesa structure includes a quantum well region disposed between an n-doped semiconductor layer and a p-doped semiconductor region. The n-doped semiconductor layer forms a tapered semiconductor pre-waveguide. The tapered dielectric waveguide has a lower refractive index than a higher refractive index of the tapered semiconductor pre-waveguide.

## Description

### TECHNICAL FIELD

This disclosure relates generally to light sources, and in particular to micro-LEDs.

### BACKGROUND

For LEDs, it is desirable to increase the light extraction of the LED so that the brightness of the LED is enhanced for the same amount of electrical power. LEDs and micro-LEDs may be used in displays. Modern display technologies include liquid crystal displays (LCD) panels, projectors, micro-LED display, Liquid Crystal on Silicon (LCOS) displays, and even transparent displays. Common performance metrics of displays include brightness measurements. Certain display technologies are better suited for different contexts based on size, power, and desirable performance metrics.

### SUMMARY

According to a first aspect, there is provided a micro-LED comprising: a mesa structure including a quantum well region disposed between an n-doped semiconductor layer and a p-doped semiconductor region, wherein the n-doped semiconductor layer forms a tapered semiconductor pre-waveguide that is narrowest at an interface with the quantum well region and/or is widest at a curved semiconductor exit surface of the tapered semiconductor pre-waveguide; and a tapered dielectric waveguide having a lower refractive index than a higher refractive index of the tapered semiconductor pre-waveguide, wherein the tapered dielectric waveguide narrows as it approaches the tapered semiconductor pre-waveguide and/or is widest at a curved dielectric exit surface of the tapered dielectric waveguide.

A top of the tapered semiconductor pre-waveguide may be approximately spherical.

A top of the tapered dielectric waveguide may be approximately spherical.

The micro-LED may further comprise a dielectric layer formed between the tapered dielectric waveguide and the tapered semiconductor pre-waveguide. A middle refractive index of the dielectric layer may be between the lower refractive index and the higher refractive index.

The micro-LED may further comprise an oxide layer disposed around the tapered dielectric waveguide. The oxide layer may have an oxide refractive index that is lower than the lower refractive index of the tapered dielectric waveguide.

The oxide layer may contact the tapered dielectric waveguide without contacting the tapered semiconductor pre-waveguide.

A thin oxide layer of the oxide layer may be disposed over a dielectric exit surface of the tapered dielectric waveguide.

Dielectric sidewalls of the tapered dielectric waveguide may be configured to provide an emission cone angle of between 16 degrees to 20 degrees.

Dielectric sidewalls of the tapered dielectric waveguide may be disposed at a slant angle of between 10 degrees and 12 degrees with respect to an emission optical axis of the micro-LED.

Dielectric sidewalls of the tapered dielectric waveguide may be disposed at a slant angle that is a continuation of semiconductor sidewalls of the tapered semiconductor pre-waveguide.

The micro-LED may further comprise: an oxide layer disposed around the mesa structure; and a reflective layer disposed around the mesa structure. The oxide layer may be disposed between the reflective layer and the mesa structure.

The micro-LED may further comprise an n-contact layer configured to electrically bias the n-doped semiconductor layer of the tapered semiconductor pre-waveguide. The tapered semiconductor pre-waveguide may include a thin collar region disposed around the tapered semiconductor pre-waveguide below a semiconductor exit surface of the tapered semiconductor pre-waveguide. The thin collar region may contact the n-contact layer.

The tapered dielectric waveguide may contact the n-contact layer and may contact the thin collar region.

The tapered dielectric waveguide may be formed of silicon nitride.

The micro-LED may further comprise an anti-reflective, AR, layer formed between the tapered dielectric waveguide and the tapered semiconductor pre-waveguide. A middle refractive index of the AR layer may be between the lower refractive index and the higher refractive index.

According to a second aspect, there is provided a display including a display pixel array, wherein the display pixel array includes micro-LEDs according to the first aspect.

According to a third aspect, there is provided a head mounted display, HMD, comprising: a frame; and a display pixel array configured to provide virtual images included in display light to an eyebox region of the HMD, wherein the display pixel array includes micro-LEDs according to the first aspect.

### BRIEF DESCRIPTION OF THE DRAWINGS

Non-limiting and non-exhaustive examples of the invention are described with reference to the following figures, wherein like reference numerals refer to like parts throughout the various views unless otherwise specified.
FIG. 1 illustrates a side view of micro-LED structure including a mesa structure including a p-doped semiconductor layer, quantum well region, and an n-doped semiconductor layer, in accordance with aspects of the disclosure.
FIG. 2A illustrates a side view of micro-LED structure including a tapered semiconductor pre-waveguide and a tapered dielectric waveguide, in accordance with aspects of the disclosure.
FIG. 2B illustrates a zoomed in view of a portion of the micro-LED structure illustrated in FIG. 2A, in accordance with aspects of the disclosure.
FIG. 3A illustrates a micro-LED structure including a planar exit surface, in accordance with aspects of the disclosure.
FIG. 3B illustrates a micro-LED structure having a thinner oxide layer around a tapered dielectric waveguide than the micro-LED structure of FIG. 3A, in accordance with aspects of the disclosure.
FIG. 3C illustrates a micro-LED structure having a metal n-contact, in accordance with aspects of the disclosure.
FIG. 3D illustrates a micro-LED structure having a metal layer contacting a tapered dielectric waveguide, in accordance with aspects of the disclosure.
FIG. 4 illustrates a micro-LED structure having a nano-structure exit surface, in accordance with aspects of the disclosure.
FIG. 5 illustrates a micro-LED structure including a middle tapered waveguide disposed between a tapered dielectric waveguide and a tapered semiconductor pre-waveguide, in accordance with aspects of the disclosure.
FIG. 6 illustrates a micro-LED structure including an elongated tapered semiconductor pre-waveguide, in accordance with aspects of the disclosure.
FIG. 7 illustrates a display system including a display pixel array including micro-LEDs, in accordance with aspects of the disclosure.
FIG. 8 illustrates a head mounted display (HMD) that may include a display pixel array, in accordance with aspects of the disclosure.

### DETAILED DESCRIPTION

Examples of micro-LEDs having improved light extraction efficiency are described herein. In the following description, numerous specific details are set forth to provide a thorough understanding of the examples. One skilled in the relevant art will recognize, however, that the techniques described herein can be practiced without one or more of the specific details, or with other methods, components, materials, etc. In other instances, well-known structures, materials, or operations are not shown or described in detail to avoid obscuring certain aspects.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

In some implementations of the disclosure, the term "near-eye" may be defined as including an element that is configured to be placed within 50 mm of an eye of a user while a near-eye device is being utilized. Therefore, a "near-eye optical element" or a "near-eye system" would include one or more elements configured to be placed within 50 mm of the eye of the user.

In aspects of this disclosure, visible light may be defined as having a wavelength range of approximately 380 nm - 700 nm. Non-visible light may be defined as light having wavelengths that are outside the visible light range, such as ultraviolet light and infrared light. Infrared light having a wavelength range of approximately 700 nm - 1 mm includes near-infrared light. In aspects of this disclosure, near-infrared light may be defined as having a wavelength range of approximately 700 nm - 1.6 µm.

In aspects of this disclosure, the term "transparent" may be defined as having greater than 90% transmission of light. In some aspects, the term "transparent" may be defined as a material having greater than 90% transmission of visible light.

Engineers and physicists are continually looking for ways to increase the efficiency of LEDs. Historically, improvements in semiconductor materials, semiconductor doping, semiconductor structures, and optical improvements have enhanced LED efficiency.

Power efficiency in LEDs may have increased importance for battery-operated devices and in certain contexts such as wearables. As an example, head-mounted displays (HMDs) such as augmented reality (AR) glasses, virtual reality (VR) headsets, or mixed reality (MR) headsets may include micro-LED displays to present virtual images to users of the HMD. Yet, because the space for batteries may be limited, the efficiency of micro-LEDs in HMDs has increased importance.

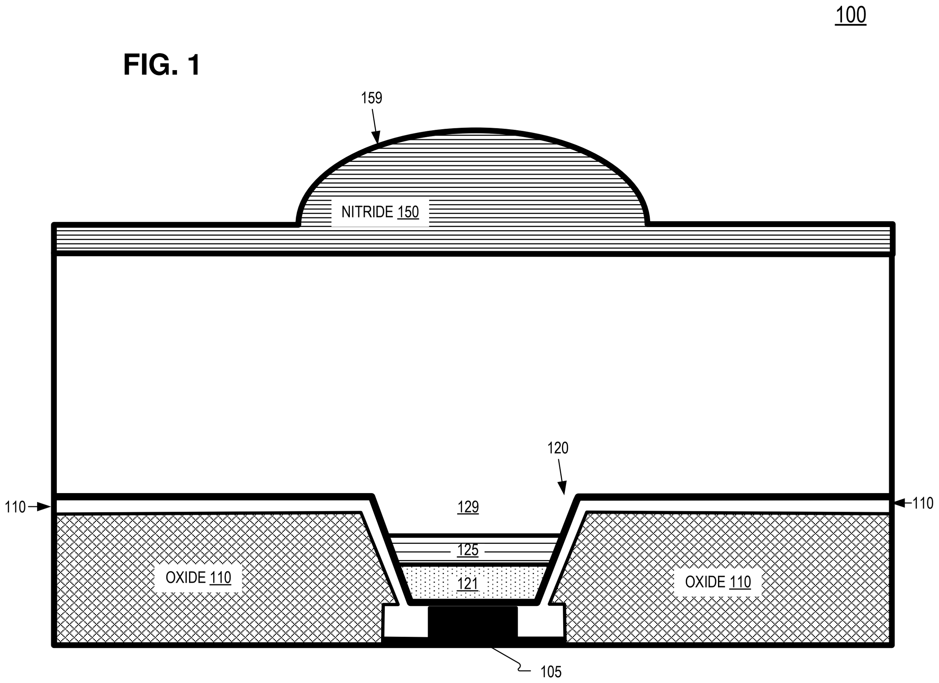

In implementations of the disclosure, micro-LEDs and displays including micro-LEDs with increased efficiency are disclosed. Micro-LEDs of the disclosure may have a width of less than 10 microns and a height of less than 5 microns, in some implementations. In implementations, the micro-LED includes a tapered semiconductor pre-waveguide and a tapered dielectric waveguide. The exit surfaces of the tapered semiconductor pre-waveguide and the tapered dielectric waveguide may be curved to increase light efficiency extraction. The curve may be spherical or approximately spherical, in some implementations. An anti-reflection (AR) coating layer may be disposed between the tapered semiconductor pre-waveguide and the tapered dielectric waveguide, in some implementations. The AR coating may have a refractive index between the tapered semiconductor pre-waveguide and the tapered dielectric waveguide, in order to increase light extraction. In some implementations, an oxide layer is disposed over the exit surface of the tapered dielectric waveguide, where the oxide layer has a lower refractive index than the tapered dielectric waveguide. These and other examples are described in more detail in connection with FIGs. 1-8.

FIG. 1 illustrates a side view of micro-LED structure 100 including a mesa structure 120 including a p-doped semiconductor layer 121, quantum well region 125, and an n-doped semiconductor layer 129. Quantum well region 125 is disposed between the n-doped semiconductor layer 129 and the p-doped semiconductor layer 121. While not specifically illustrated, a p-doped unintentionally doped (UID) layer may be disposed between p-doped semiconductor layer 121 and quantum well region 125. Similarly, an n-doped unintentionally doped (UID) layer may be disposed between n-doped semiconductor layer 129 and quantum well region 125. A number of quantum wells in quantum well region 125 is 20 or more, in some implementations. P-doped semiconductor layer 121 and n-doped semiconductor layer 129 may include Aluminum-Indium-Gallium-Phosphorus (AlinGaP), for example.

In operation, micro-LED structure 100 may emit red light 191 (e.g. around 630 nm) when a voltage is applied across p-contact 105 and n-doped semiconductor layer 129. Red light is emitted from quantum well region 125 and a portion of the red light propagates through the n-doped semiconductor layer 129 and encounters nitride layer 150. Nitride (Si3N4) layer 150 includes a curved exit surface 159 that assists in extracting red light from micro-LED structure 100. The curved exit surface 159 reduces reflections of red light 191 back into micro-LED structure 100 and encourages light 191 to exit the micro-LED structure.

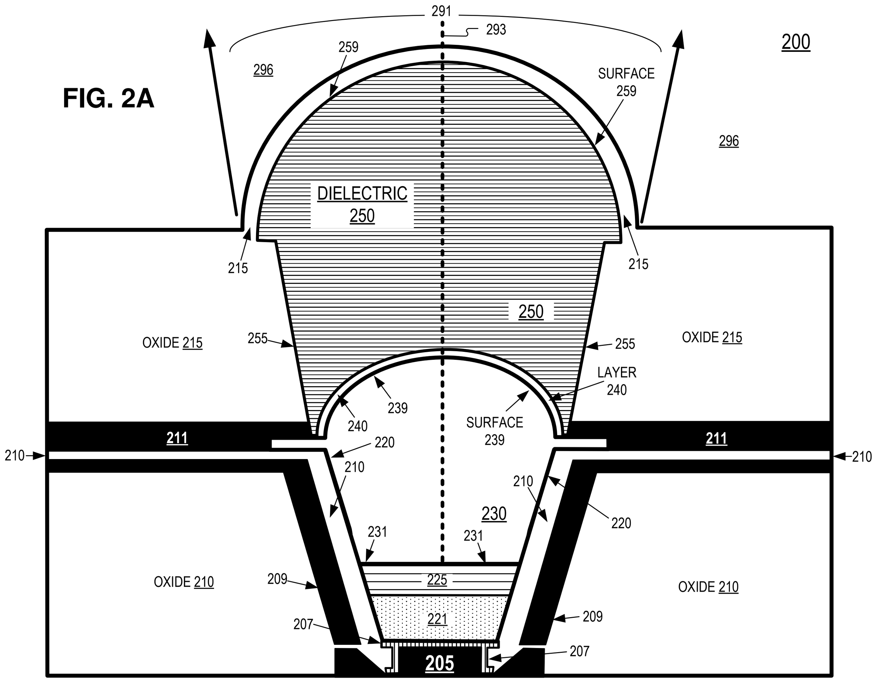

FIG. 2A illustrates a side view of micro-LED structure 200 including a tapered semiconductor pre-waveguide and a tapered dielectric waveguide, in accordance with aspects of the disclosure. Micro-LED structure 200 includes a mesa structure 220 including a p-doped semiconductor layer 221, quantum well region 225, and an n-doped semiconductor layer that forms a tapered semiconductor pre-waveguide 230. Quantum well region 225 is disposed between the tapered semiconductor pre-waveguide 230 (formed of the n-doped semiconductor layer) and the p-doped semiconductor layer 221. Quantum well region 225 may have a thickness of between 80 nm and 120 nm, in some implementations. While not specifically illustrated, a p-doped unintentionally doped (UID) layer may be disposed between p-doped semiconductor layer 221 and quantum well region 225. Similarly, an n-doped unintentionally doped (UID) layer may be disposed between the n-doped semiconductor layer of pre-waveguide 230 and quantum well region 225. A number of quantum wells in quantum well region 225 is 20 or more, in some implementations. P-doped semiconductor layer 221 and the n-doped semiconductor layer of pre-waveguide 230 may include Aluminum-Indium-Gallium-Phosphorus (AllnGaP), for example.

In FIG. 2A, a portion of the n-doped semiconductor layer included in pre-waveguide 230 is included in mesa structure 220 while also extending to form the rest of tapered semiconductor pre-waveguide 230 that is widest at a curved semiconductor exit surface 239 and narrowest at an interface 231 with quantum well region 225. Curved semiconductor exit surface 239 may have a spherical shape, in some implementations. The curved nature of semiconductor exit surface 239 may increase light extraction by reducing undesirable Fresnel reflection compared to a planar exit surface.

Tapered semiconductor pre-waveguide 230 is disposed between quantum wells region 225 and tapered dielectric waveguide 250. When light is emitted from quantum wells region 225, the light is guided to tapered dielectric waveguide 250 by tapered semiconductor pre-waveguide 230. Tapered dielectric waveguide 250 has a lower refractive index than a higher refractive index of the tapered semiconductor pre-waveguide 230 to encourage light to propagate from tapered semiconductor pre-waveguide 230 to tapered dielectric waveguide 250. Tapered dielectric waveguide 250 is configured to guide the light received from pre-waveguide 230 to exit a curved dielectric exit surface 259. Curved dielectric exit surface 259 may have a spherical shape, in some implementations.

FIG. 2A illustrates that an anti-reflective (AR) layer 240 may be formed between tapered dielectric waveguide 250 and tapered semiconductor pre-waveguide 230. AR layer 240 may have a middle refractive index that is between a lower refractive index of tapered dielectric waveguide 250 and the higher refractive index of tapered semiconductor pre-waveguide 230. In some implementations, AR layer 240 may be a dielectric layer. By way of illustration, tapered semiconductor pre-waveguide 230 may have a refractive index of approximately 3.5, AR layer 240 may have a refractive index of approximately 2.4, and tapered dielectric waveguide 250 may have a refractive index of approximately 2. This arrangement of the layers creates a refractive index gradient propagating from higher refractive index materials to lower refractive index materials to enhance light extraction of micro-LED structure 200.

In an implementation, tapered semiconductor pre-waveguide 230 is formed of Aluminum-Indium-Gallium-Phosphorus (AlInGaP). In an implementation, AR layer 240 includes niobium oxide (Nb2O5). In an implementation, AR layer 240 has a thickness of approximately 60 nm. In an implementation, AR layer 240 has a thickness of approximately 80 nm. In an implementation, AR layer 240 has a thickness of approximately 100 nm. AR layer 240 may have a thickness between 50 nm and 120 nm, in some implementations. FIG. 2A illustrates that AR layer 240 may follow the curvature of curved semiconductor exit surface 239. In an implementation, tapered dielectric waveguide 250 includes silicon nitride (Si3N4).

FIG. 2A illustrates that an oxide layer 215 may be disposed around tapered dielectric waveguide 250. Oxide layer 215 has an oxide refractive index that is lower than the lower refractive index of the tapered dielectric waveguide 250. For example, the oxide refractive index of oxide layer 215 may be approximately 1.5. In some implementations, oxide layer 215 includes silicon dioxide (SiO2).

In some implementations, a thin oxide layer of oxide layer 215 is disposed over curved dielectric exit surface 259 of tapered dielectric waveguide 250. Since oxide layer 215 has an oxide refractive index that is less than tapered dielectric waveguide 250, the thin oxide layer of oxide layer 215 disposed over curved dielectric exit surface 259 encourages light extraction from tapered dielectric waveguide 250 to the thin oxide layer, and ultimately exiting into free space 296 (e.g. air).

Micro-LED structure 200 further includes an oxide layer 210 disposed around mesa structure 220. A reflective layer 209 is also disposed around mesa structure 220. Reflective layer 209 may include metals to reflect light emitted from quantum well region 225 back into mesa structure 220 so that the light can be emitted in the direction of free space 296. Reflective layer 209 may be aluminum or silver, for example. In FIG. 2A, oxide 210 is disposed between reflective layer 209 and mesa 220. A thin indium tin oxide (ITO) layer 207 may be disposed between p-contact 205 and p-doped semiconductor layer 221, in some implementations.

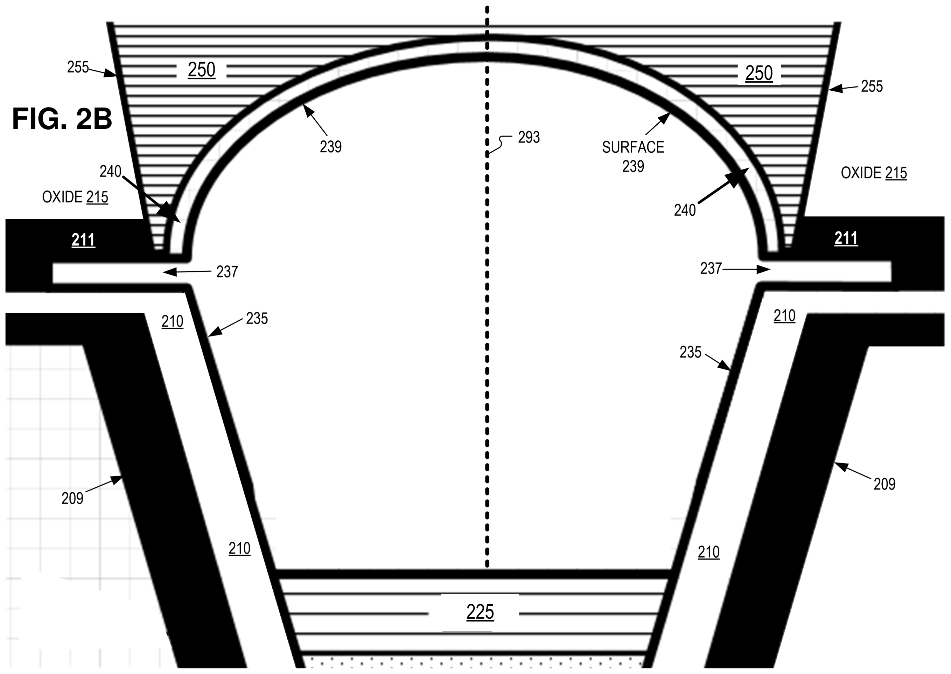

FIG. 2B illustrates a zoomed in view of a portion of micro-LED structure 200 in FIG. 2A, in accordance with aspects of the disclosure. FIG. 2B illustrates n-contact layer 211 configured to electrically bias the n-doped semiconductor region of the tapered semiconductor pre-waveguide 230 by contacting a thin collar region 237 of tapered semiconductor pre-waveguide 230. Tapered semiconductor pre-waveguide 230 includes a thin collar region 237 disposed around tapered semiconductor pre-waveguide 230 below semiconductor exit surface 239 of tapered semiconductor pre-waveguide 230. Region 237 is kept thin to reduce lateral waveguide action of light emitted by quantum well region 225. Thin collar region 237 may have a thickness of approximately 100 nm. Thin collar region 237 of tapered semiconductor pre-waveguide 230 contacts n-contact layer 211 so that the n-doped semiconductor region of tapered semiconductor pre-waveguide 230 can be electrically biased with a voltage. Tapered dielectric waveguide 250 contacts n-contact layer 211 and contacts thin collar region 237, in the implementation of FIG. 2B. FIG. 2B shows that oxide layer 215 may contact tapered dielectric waveguide 250 without contacting tapered semiconductor pre-waveguide 230 near thin collar region 237.

The tapered nature of the tapered semiconductor pre-waveguide 230 is at least partially defined by sidewalls 235 in FIG. 2B. Sidewalls 235 may form a portion of a three-dimensional (3D) inverted cone of n-doped semiconductor layer included in pre-waveguide 230.

Dielectric sidewalls 255 of the tapered dielectric waveguide 250 may be disposed at a slant angle that is a continuation of semiconductor sidewalls 235 of the tapered semiconductor pre-waveguide 230. Dielectric sidewalls 255 of the tapered dielectric waveguide 250 are disposed at a slant angle of between 10 degrees and 12 degrees with respect to an emission optical axis 293 of the micro-LED structure 200. The tapered angle of dielectric sidewalls 255 may be formed by carefully controlling etching parameters (e.g. etch time and etch composition) in oxide layer 215. The etching of oxide layer 215 may be a reactive ion etching (RIE) or a wet etching process. Once the tapered sidewalls 255 are formed, any remaining photoresist may be stripped away and the void formed by etching oxide 215 may be filled with a dielectric material (e.g. silicon nitride or niobium pentoxide). Returning again to FIG. 2A, the void (defined by sidewalls 255) may be overfilled with the dielectric material so that curved exit surface 259 can be etched from the overfill in a subtractive process. To etch a curved surface to form curved exit surface 259, a photoresist material can be applied to the dielectric material overfilling the cavity formed by sidewalls 255. The photoresist material may then be exposed to ultraviolet (UV) light through a mask that has the desire micro-lens pattern for curved exit surface 259. This exposure causes a chemical change in the photoresist material, making the exposed areas either more soluble or less soluble depending on whether a positive or negative photoresist is used. Subsequently, the dielectric material is etched to selectively remove the dielectric material from areas not protected by the photoresist. The result of this etching forms the desired shape of curved exit surface 259.

Dielectric sidewalls 255 of the tapered dielectric waveguide 250 are configured to provide an emission cone angle 291 of between 16 degrees to 20 degrees. An emission cone angle 291 of between 16 and 20 degrees may be desirable for contexts where micro-LEDs are utilized in a micro-display, whereas that emission cone angle may be less desirable for other contexts. In some implementations, dielectric sidewalls 255 of the tapered dielectric waveguide 250 are configured to provide an emission cone angle 291 of between 18 degrees to 19 degrees.

In operation, micro-LED structure 200 may emit red light (e.g. around 630 nm) when a voltage is applied across p-contact 205 and the n-doped semiconductor layer of pre-waveguide 230. Red light is emitted from quantum well region 225 and a portion of the red light propagates through pre-waveguide 230 and exits curved semiconductor exit surface 239 (optionally through AR layer 240) and encounters tapered dielectric waveguide 250. Tapered dielectric waveguide 250 includes a curved dielectric exit surface 259 that assists in extracting the light from micro-LED structure 200. The light may also propagate through the thin oxide layer of oxide layer 215 that is disposed along the curve of curved dielectric exit surface 259.

In implementations of the disclosure, forming the designed curvature of exit surfaces 239 may include utilizing resist-reflow techniques that include disposing patterned resist on the surface of the n-doped semiconductor layer of pre-waveguide 230 and then reflowing the n-doped semiconductor layer to form the desired curvature (e.g. spherical). Forming curved dielectric exit surface 259 may utilize a similar resist-reflow technique to form the desired curvature of curved dielectric exit surface 259. Notably, the n-doped semiconductor region in FIG. 2A has been thinned down compared to the much thicker n-doped semiconductor region in FIG. 1.

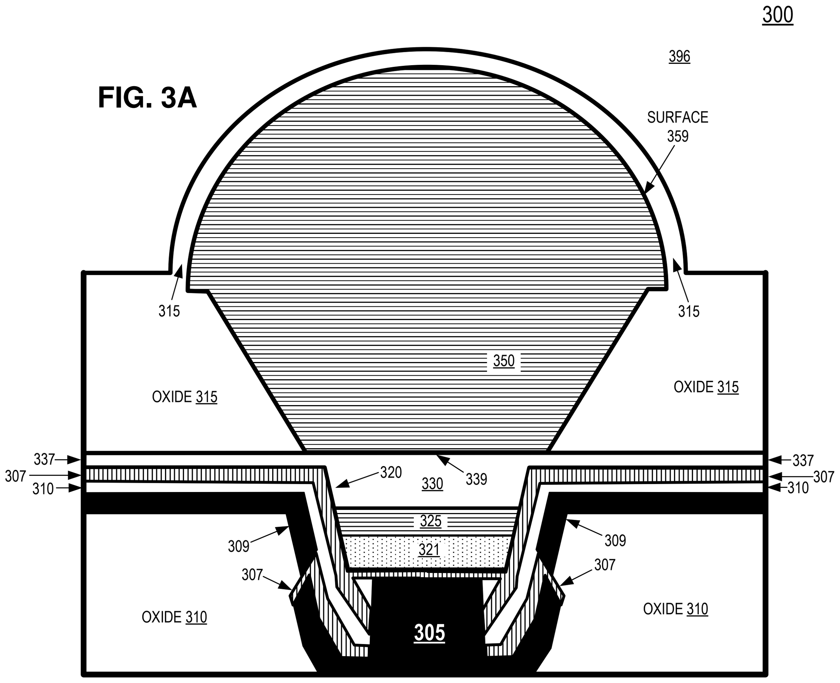

FIG. 3A illustrates a micro-LED structure 300 including a planar exit surface 339, in accordance with aspects of the disclosure. Micro-LED structure 300 differs from micro-LED structure 200 in that exit surface 339 is planar instead of a curved exit surface (e.g. curved exit surface 259). Additionally, thin collar region 237 and n-contact layer 211 of micro-LED structure 200 are replaced with a thin planar extension portion 337 of tapered semiconductor pre-waveguide 330.

Micro-LED structure 300 includes a mesa structure 320 including a p-doped semiconductor layer 321, quantum well region 325, and an n-doped semiconductor layer that forms a tapered semiconductor pre-waveguide 330. Quantum well region 325 is disposed between the tapered semiconductor pre-waveguide 330 (formed of the n-doped semiconductor layer) and the p-doped semiconductor layer 321. Quantum well region 325 may have a thickness of between 80 nm and 120, in some implementations. While not specifically illustrated, a p-doped unintentionally doped (UID) layer may be disposed between p-doped semiconductor layer 321 and quantum well region 325. Similarly, an n-doped unintentionally doped (UID) layer may be disposed between the n-doped semiconductor layer of pre-waveguide 330 and quantum well region 325. A number of quantum wells in quantum well region 325 is 20 or more, in some implementations. P-doped semiconductor layer 321 and the n-doped semiconductor layer of pre-waveguide 330 may include Aluminum-Indium-Gallium-Phosphorus (AlInGaP), for example.

Tapered semiconductor pre-waveguide 330 is disposed between quantum wells region 325 and tapered dielectric waveguide 350. When light is emitted from quantum wells region 325, the light is guided to tapered semiconductor waveguide 350 by tapered dielectric pre-waveguide 330. In an implementation, tapered dielectric waveguide 350 includes silicon nitride (Si3N4). Tapered dielectric waveguide 350 has a lower refractive index than a higher refractive index of the tapered semiconductor pre-waveguide 330 to encourage light to propagate from tapered semiconductor pre-waveguide 330 to tapered dielectric waveguide 350. Tapered dielectric waveguide 350 is configured to guide the light received from pre-waveguide 330 to exit a curved dielectric exit surface 359. Curved dielectric exit surface 359 may have a spherical shape, in some implementations.

FIG. 3A illustrates that an oxide layer 315 may be disposed around tapered dielectric waveguide 350. Oxide layer 315 has an oxide refractive index that is lower than the lower refractive index of the tapered dielectric waveguide 350. For example, the oxide refractive index of oxide layer 315 may be approximately 1.5. In some implementations, oxide layer 315 includes silicon dioxide (SiO2).

In some implementations, a thin oxide layer of oxide layer 315 is disposed over curved dielectric exit surface 359 of tapered dielectric waveguide 350. Since oxide layer 315 has an oxide refractive index that is less than tapered dielectric waveguide 350, the thin oxide layer of oxide layer 315 disposed over curved dielectric exit surface 359 encourages light extraction from tapered dielectric waveguide 350 to the thin oxide layer, and ultimately exiting into free space 396 (e.g. air).

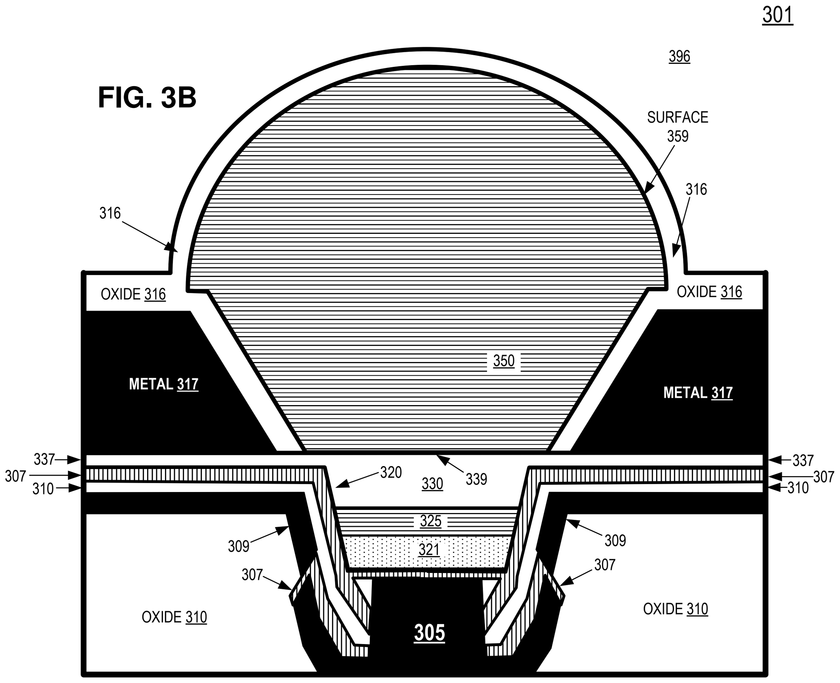

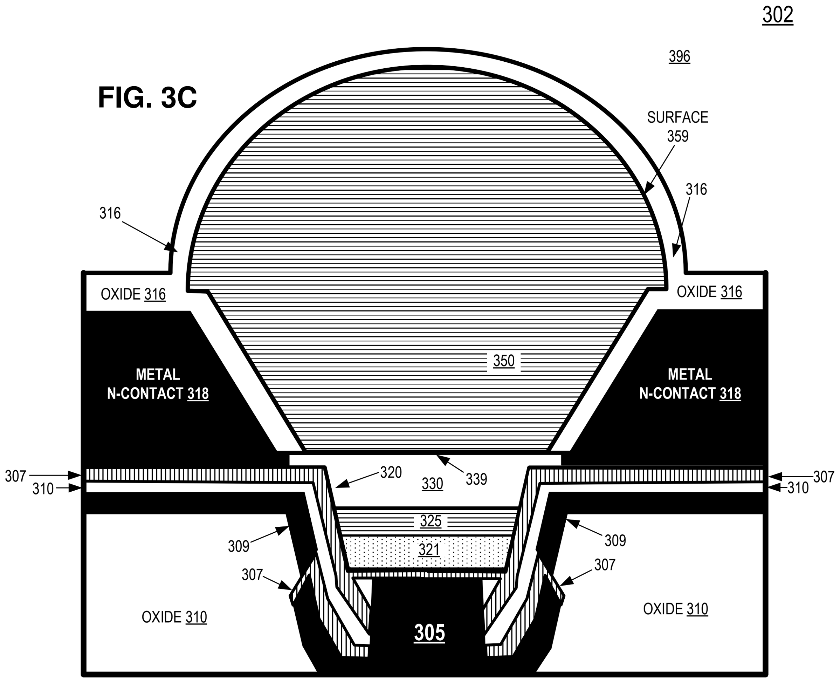

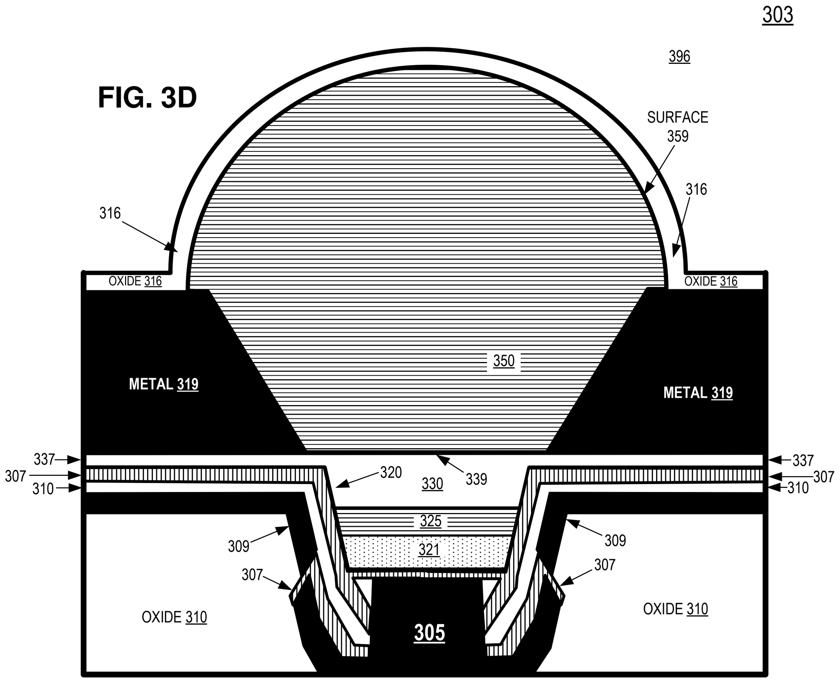

Micro-LED structure 300 further includes an oxide layer 310 disposed around mesa structure 320. A reflective layer 309 is also disposed around mesa structure 320. Reflective layer 309 may include metals to reflect light emitted from quantum well region 325 back into mesa structure 320 so that the light can be emitted in the direction of free space 396. Reflective layer 309 may be aluminum or silver, for example. In FIG. 3, oxide 310 is disposed between reflective layer 309 and mesa 320. A thin dielectric layer 307 (e.g. silicon nitride) may be disposed between p-contact 305 and p-doped semiconductor layer 321, in some implementations.

In operation, micro-LED structure 300 may emit red light (e.g. around 630 nm) when a voltage is applied across p-contact 305 and the n-doped semiconductor layer of pre-waveguide 330. Red light is emitted from quantum well region 325 and a portion of the red light propagates through the pre-waveguide 330 and exits planar exit surface 339 and encounters tapered dielectric waveguide 350. Tapered dielectric waveguide 350 includes a curved dielectric exit surface 359 that assists in extracting the light from micro-LED structure 300. The light may also propagate through the thin oxide layer of oxide layer 315 that is disposed along the curve of curved dielectric exit surface 359.

FIG. 3B illustrates a micro-LED structure 301 having a thinner oxide layer 316 around tapered dielectric waveguide 350 than micro-LED structure 300 of FIG. 3A, in accordance with aspects of the disclosure. Oxide layer 316 around tapered dielectric waveguide 350 is thinner than oxide layer 315 in FIG. 3A while still enhancing reflectivity of emitted light along the interface between waveguide 350 and oxide layer 316. Metal layer 317 is disposed around oxide layer 316. Metal layer 317 may include aluminum or gold, for example.

FIG. 3C illustrates a micro-LED structure 302 having a metal n-contact 318, in accordance with aspects of the disclosure. Micro-LED structure 302 differs from micro-LED structure 301 of FIG. 3B in that metal n-contact 318 extends down and contacts layer 307.

FIG. 3D illustrates a micro-LED structure 303 having a metal layer 319 contacting tapered dielectric waveguide 350, in accordance with aspects of the disclosure. Micro-LED structure 303 is similar to micro-LED structure 301 except that instead of relying on the interface of two refractive materials (waveguide 350 and the thin oxide layer 316 around waveguide 350) to enhance reflectivity, micro-LED structure 303 relies on metal layer 319 to reflect emitted light back into waveguide 350. Metal layer 319 may be aluminum or gold, for example.

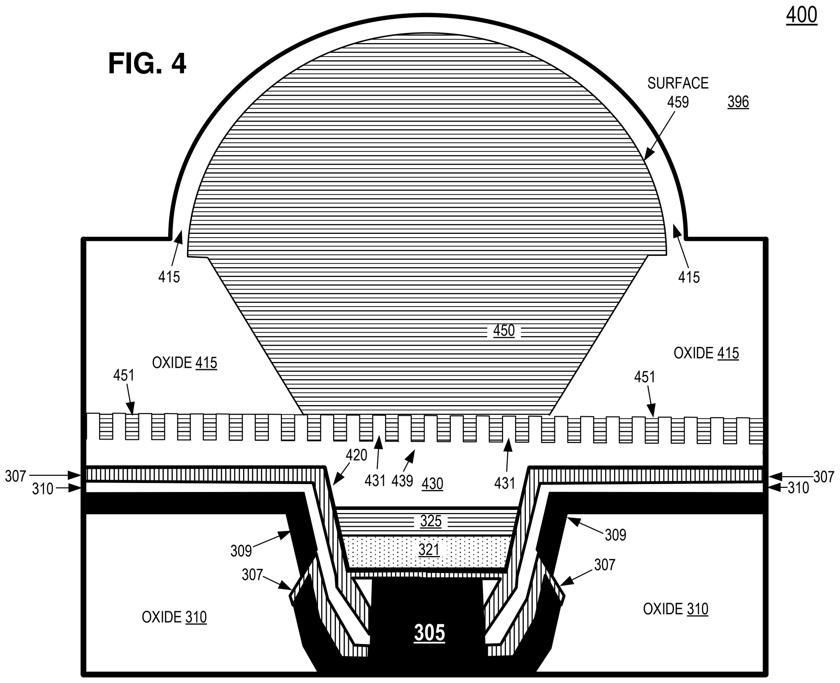

FIG. 4 illustrates a micro-LED structure 400 having a nano-structure exit surface 439, in accordance with aspects of the disclosure. Micro-LED structure 400 differs from micro-LED structure 400 in that exit surface 439 includes a nano-structure exit surface 439 instead of being planar (e.g. exit surface 359).

Micro-LED structure 400 includes a mesa structure 420 including a p-doped semiconductor layer 321, quantum well region 325, and an n-doped semiconductor layer that forms a tapered semiconductor pre-waveguide 430. Quantum well region 325 is disposed between the tapered semiconductor pre-waveguide 430 (formed of the n-doped semiconductor layer) and the p-doped semiconductor layer 321. While not specifically illustrated, a p-doped unintentionally doped (UID) layer may be disposed between p-doped semiconductor layer 321 and quantum well region 325. Similarly, an n-doped unintentionally doped (UID) layer may be disposed between the n-doped semiconductor layer of pre-waveguide 430 and quantum well region 325. P-doped semiconductor layer 321 and the n-doped semiconductor layer of pre-waveguide 430 may include Aluminum-Indium-Gallium-Phosphorus (AllnGaP), for example.

Tapered semiconductor pre-waveguide 430 is disposed between quantum wells region 325 and tapered dielectric waveguide 450. When light is emitted from quantum wells region 325, the light is guided to tapered dielectric waveguide 450 by tapered semiconductor pre-waveguide 430. In an implementation, tapered dielectric waveguide 450 includes silicon nitride (Si3N4). Tapered dielectric waveguide 450 has a lower refractive index than a higher refractive index of the tapered semiconductor pre-waveguide 430 to encourage light to propagate from tapered semiconductor pre-waveguide 430 to tapered dielectric waveguide 450. Tapered dielectric waveguide 450 is configured to guide the light received from pre-waveguide 430 to exit a curved dielectric exit surface 459. Curved dielectric exit surface 459 may have a spherical shape, in some implementations.

In operation, micro-LED structure 400 may emit red light (e.g. around 630 nm) when a voltage is applied across p-contact 305 and the n-doped semiconductor layer of pre-waveguide 430. Red light is emitted from quantum well region 325 and a portion of the red light propagates through the pre-waveguide 430 and exits nano-structure exit surface 439 and encounters tapered dielectric waveguide 450. In FIG. 4, nano-structure exit surface 439 is formed of nano-features 431 having nano-fill material 451 disposed between the nano-features 431. Nano-fill material 451 may be the same material forming tapered dielectric waveguide 450. In the illustrated implementation of FIG. 4, nano-features 431 are illustrated as pillars, however other geometric features may be used for nano-features 431. The pillars may be cylindrical. Nano-features 431 may be "sub-wavelength" sized compared to the wavelength of light emitted from quantum well region 325. For example, for red light having a wavelength of approximately 630 nm, the largest dimension of nano-feature 431 may be less than 630 nm. The height, width, and/or spacing of nano-pillars 431 may be altered to achieve an engineered light extraction efficiency for light encountering nano-structure exit surface 439.

In some implementations, a thin oxide layer of oxide layer 415 is disposed over curved dielectric exit surface 459 of tapered dielectric waveguide 450. Since oxide layer 415 has an oxide refractive index that is less than tapered dielectric waveguide 450, the thin oxide layer of oxide layer 415 disposed over curved dielectric exit surface 459 encourages light extraction from tapered dielectric waveguide 450 to the thin oxide layer, and ultimately exiting into free space 396 (e.g. air).

Tapered dielectric waveguide 450 includes a curved dielectric exit surface 459 that assists in extracting the light from micro-LED structure 400. The light may also propagate through the thin oxide layer of oxide layer 415 that is disposed along the curve of curved dielectric exit surface 459.

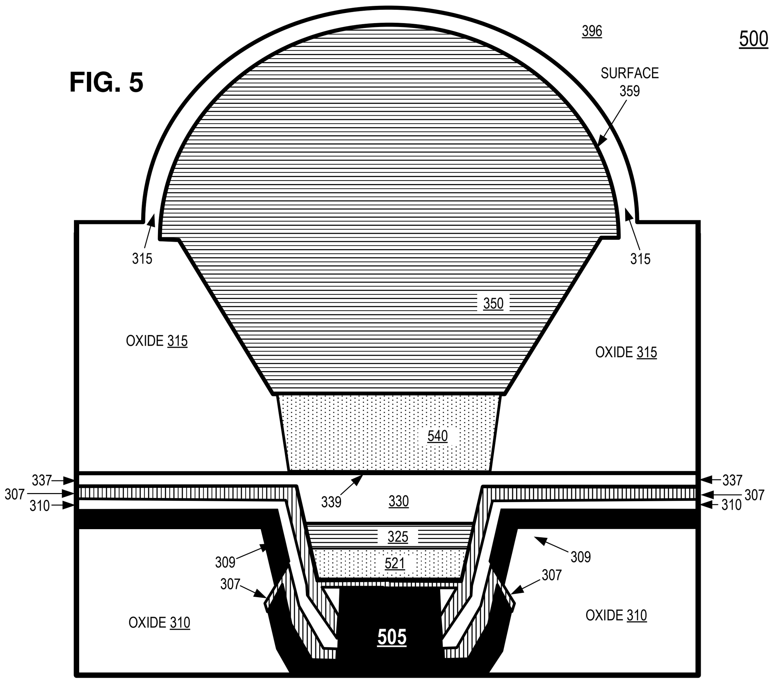

FIG. 5 illustrates a micro-LED structure 500 including a middle tapered waveguide 540 disposed between tapered dielectric waveguide 350 and a tapered semiconductor pre-waveguide 330, in accordance with aspects of the disclosure. Micro-LED structure 500 is similar to micro-LED structure 300 except that a middle tapered waveguide 540 is disposed between tapered dielectric waveguide 350 and a tapered semiconductor pre-waveguide 330. In FIG. 5, tapered dielectric waveguide 350 has a lower refractive index than middle tapered waveguide 540 and middle tapered waveguide 540 has a lower refractive index than tapered semiconductor pre-waveguide 330. In an implementation, tapered dielectric waveguide 350 includes silicon nitride and middle tapered waveguide 540 includes niobium pentoxide. In some implementations titanium dioxide (TiO2) can be used as middle tapered waveguide 540.

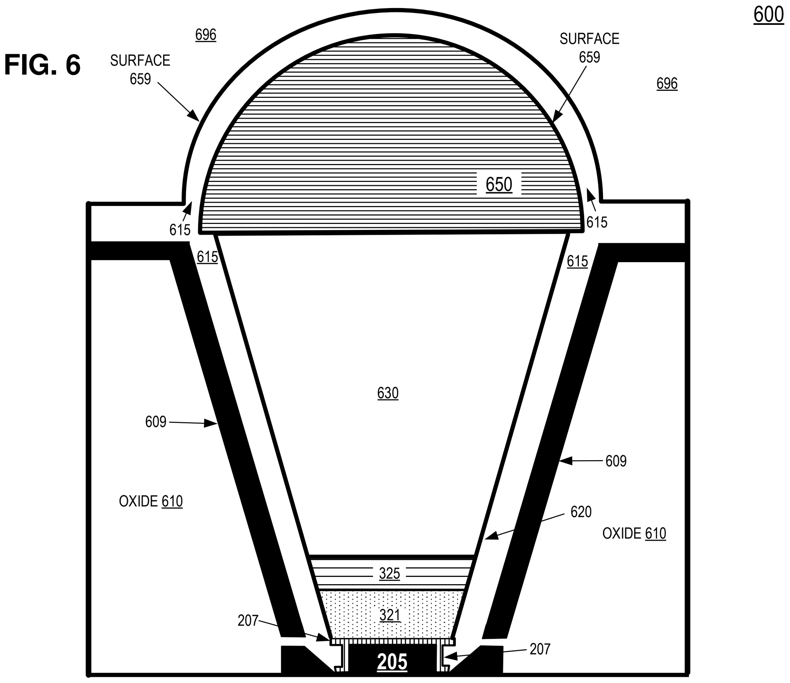

FIG. 6 illustrates a micro-LED structure 600 including an elongated tapered semiconductor pre-waveguide 630, in accordance with aspects of the disclosure. Micro-LED structure 600 includes a mesa structure 620 including a p-doped semiconductor layer 321, quantum well region 325, and an n-doped semiconductor layer that forms an elongated tapered semiconductor pre-waveguide 630. Quantum well region 325 is disposed between the elongated tapered semiconductor pre-waveguide 630 (formed of the n-doped semiconductor layer) and the p-doped semiconductor layer 321. While not specifically illustrated, a p-doped unintentionally doped (UID) layer may be disposed between p-doped semiconductor layer 321 and quantum well region 325. Similarly, an n-doped unintentionally doped (UID) layer may be disposed between the n-doped semiconductor layer of pre-waveguide 630 and quantum well region 325. P-doped semiconductor layer 321 and the n-doped semiconductor layer of pre-waveguide 630 may include Aluminum-Indium-Gallium-Phosphorus (AllnGaP), for example.

Elongated tapered semiconductor pre-waveguide 630 is disposed between quantum wells region 325 and dielectric lens 650. When light is emitted from quantum wells region 325, the light is guided to dielectric lens 650 by elongated tapered semiconductor pre-waveguide 630. In an implementation, dielectric lens 650 includes silicon nitride (Si3N4). Dielectric lens 650 has a lower refractive index than a higher refractive index of the elongated tapered semiconductor pre-waveguide 630 to encourage light to propagate from elongated tapered semiconductor pre-waveguide 430 to dielectric lens 650. Dielectric lens 650 is configured to guide the light received from pre-waveguide 630 to exit a curved dielectric exit surface 659 of dielectric lens 650. Curved dielectric exit surface 659 may have a spherical shape, in some implementations.

In operation, micro-LED structure 600 may emit red light (e.g. around 630 nm) when a voltage is applied across p-contact 205 and the n-doped semiconductor layer of pre-waveguide 630. Red light is emitted from quantum well region 325 and a portion of the red light propagates through the pre-waveguide 630 and encounters dielectric lens 650. In the illustrated implementation, a thin oxide layer of oxide layer 615 is disposed over curved dielectric exit surface 659 of dielectric lens 650. Since oxide layer 615 has an oxide refractive index that is less than dielectric lens 650, the thin oxide layer of oxide layer 615 disposed over curved dielectric exit surface 659 encourages light extraction from dielectric lens 650 to the thin oxide layer, and ultimately exiting into free space 696 (e.g. air).

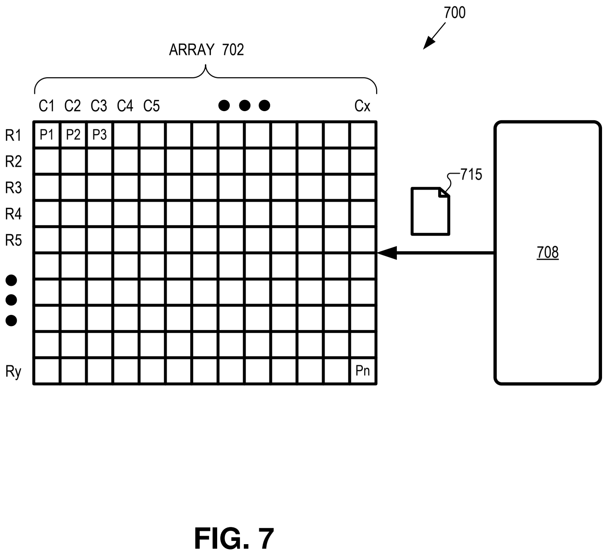

FIG. 7 illustrates a display system 700 including a display pixel array 702 including micro-LEDs, in accordance with aspects of the disclosure. Display system 700 includes processing logic 708 configured to drive image(s) 715 onto display pixel array 702. Display pixel array 702 includes n display pixels (P1, P2, P3...Pn) arranged in y rows and x columns. Each display pixel in display pixel array 702 may include a micro-LED having one of the micro-LED structures disclosed in FIGs. 2A-6. In some implementations, display pixel array 702 includes red, green, and blue display pixels and the red display pixels in the display pixel array include the micro-LED structures disclosed in FIGs. 2A-6. In some implementations, display system 700 may be included in a head mounted display (HMD). In that context, image(s) 715 may include virtual images for presenting to an eyebox region of the HMD.

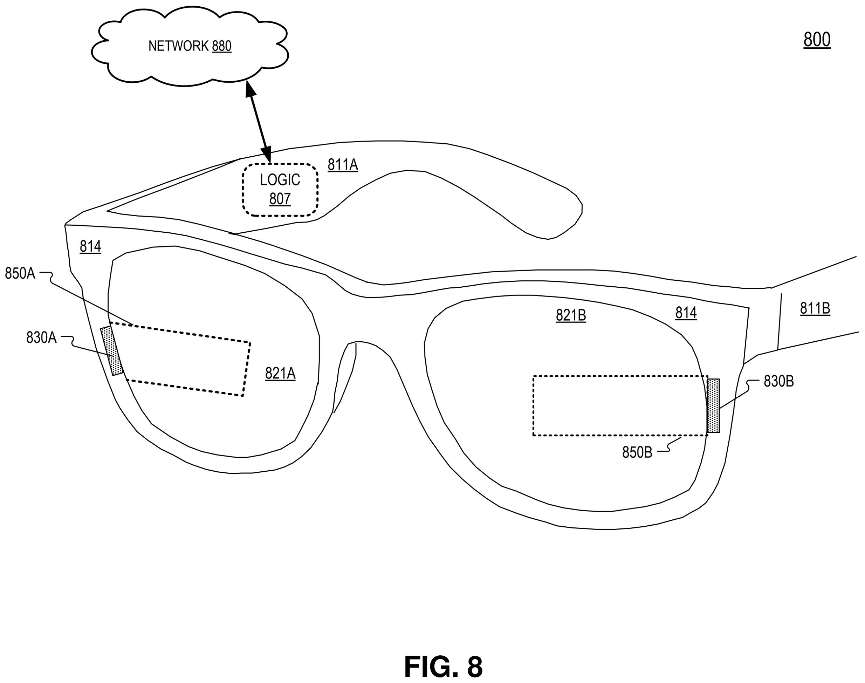

FIG. 8 illustrates a head mounted display (HMD) 800 that may include a display pixel array, in accordance with aspects of the present disclosure. HMD 800 includes frame 814 coupled to arms 811A and 811B. Lens assemblies 821A and 821B are mounted to frame 814. Lens assemblies 821A and 821B may include a prescription lens matched to a particular user of HMD 800. The illustrated HMD 800 is configured to be worn on or about a head of a wearer of HMD 800.

In the HMD 800 illustrated in FIG. 8, each lens assembly 821A/121B includes a waveguide 850A/850B to direct image light generated by displays 830A/830B to an eyebox area for viewing by a user of HMD 800. Displays 830A/830B may include micro-LEDs displays including the micro-LED structures included in the disclosure.

Lens assemblies 821A and 821B may appear transparent to a user to facilitate augmented reality or mixed reality to enable a user to view scene light from the environment around them while also receiving image light directed to their eye(s) by, for example, waveguides 850. Lens assemblies 821A and 821B may include two or more optical layers for different functionalities such as display, eye-tracking, and optical power. In some examples, display light from display 830A or 830B is only directed into one eye of the wearer of HMD 800. In an example, both displays 830A and 830B are used to direct display light into waveguides 850A and 850B, respectively.

Frame 814 and arms 811 may include supporting hardware of HMD 800 such as processing logic 807, a wired and/or wireless data interface for sending and receiving data, graphic processors, and one or more memories for storing data and computer-executable instructions. Processing logic 807 may include circuitry, logic, instructions stored in a machine-readable storage medium, ASIC circuitry, FPGA circuitry, and/or one or more processors. In one example, HMD 800 may be configured to receive wired power. In one example, HMD 800 is configured to be powered by one or more batteries. In one example, HMD 800 may be configured to receive wired data including video data via a wired communication channel. In one example, HMD 800 is configured to receive wireless data including video data via a wireless communication channel. Processing logic 807 may be communicatively coupled to a network 880 to provide data to network 880 and/or access data within network 880. The communication channel between processing logic 807 and network 880 may be wired or wireless.

Embodiments of the invention may include or be implemented in conjunction with an artificial reality system. Artificial reality is a form of reality that has been adjusted in some manner before presentation to a user, which may include, e.g., a virtual reality (VR), an augmented reality (AR), a mixed reality (MR), a hybrid reality, or some combination and/or derivatives thereof. Artificial reality content may include completely generated content or generated content combined with captured (e.g., real-world) content. The artificial reality content may include video, audio, haptic feedback, or some combination thereof, and any of which may be presented in a single channel or in multiple channels (such as stereo video that produces a three-dimensional effect to the viewer). Additionally, in some embodiments, artificial reality may also be associated with applications, products, accessories, services, or some combination thereof, that are used to, e.g., create content in an artificial reality and/or are otherwise used in (e.g., perform activities in) an artificial reality. The artificial reality system that provides the artificial reality content may be implemented on various platforms, including a head-mounted display (HMD) connected to a host computer system, a standalone HMD, a mobile device or computing system, or any other hardware platform capable of providing artificial reality content to one or more viewers.

The term "processing logic" (e.g. 708 and/or 807) in this disclosure may include one or more processors, microprocessors, multi-core processors, Application-specific integrated circuits (ASIC), and/or Field Programmable Gate Arrays (FPGAs) to execute operations disclosed herein. In some examples, memories (not illustrated) are integrated into the processing logic to store instructions to execute operations and/or store data. Processing logic may also include analog or digital circuitry to perform the operations in accordance with examples of the disclosure.

A "memory" or "memories" described in this disclosure may include one or more volatile or non-volatile memory architectures. The "memory" or "memories" may be removable and non-removable media implemented in any method or technology for storage of information such as computer-readable instructions, data structures, program modules, or other data. Example memory technologies may include RAM, ROM, EEPROM, flash memory, CD-ROM, digital versatile disks (DVD), high-definition multimedia/data storage disks, or other optical storage, magnetic cassettes, magnetic tape, magnetic disk storage or other magnetic storage devices, or any other non-transmission medium that can be used to store information for access by a computing device.

Networks may include any network or network system such as, but not limited to, the following: a peer-to-peer network; a Local Area Network (LAN); a Wide Area Network (WAN); a public network, such as the Internet; a private network; a cellular network; a wireless network; a wired network; a wireless and wired combination network; and a satellite network.

Communication channels may include or be routed through one or more wired or wireless communication utilizing IEEE 802.11 protocols, short-range wireless protocols, SPI (Serial Peripheral Interface), I2C (Inter-Integrated Circuit), USB (Universal Serial Port), CAN (Controller Area Network), cellular data protocols (e.g. 3G, 4G, LTE, 5G), optical communication networks, Internet Service Providers (ISPs), a peer-to-peer network, a Local Area Network (LAN), a Wide Area Network (WAN), a public network (e.g. "the Internet"), a private network, a satellite network, or otherwise.

A computing device may include a desktop computer, a laptop computer, a tablet, a phablet, a smartphone, a feature phone, a server computer, or otherwise. A server computer may be located remotely in a data center or be stored locally.

The processes explained above are described in terms of computer software and hardware. The techniques described may constitute machine-executable instructions embodied within a tangible or non-transitory machine (e.g., computer) readable storage medium, that when executed by a machine will cause the machine to perform the operations described. Additionally, the processes may be embodied within hardware, such as an application specific integrated circuit ("ASIC") or otherwise.

A tangible non-transitory machine-readable storage medium includes any mechanism that provides (i.e., stores) information in a form accessible by a machine (e.g., a computer, network device, personal digital assistant, manufacturing tool, any device with a set of one or more processors, etc.). For example, a machine-readable storage medium includes recordable/non-recordable media (e.g., read only memory (ROM), random access memory (RAM), magnetic disk storage media, optical storage media, flash memory devices, etc.).

The above description of illustrated examples of the invention, including what is described in the Abstract, is not intended to be exhaustive or to limit the invention to the precise forms disclosed. While specific examples of the invention are described herein for illustrative purposes, various modifications are possible within the scope of the invention, as those skilled in the relevant art will recognize.

These modifications can be made to the invention in light of the above detailed description. The terms used in the following claims should not be construed to limit the invention to the specific examples disclosed in the specification. Rather, the scope of the invention is to be determined entirely by the following claims, which are to be construed in accordance with established doctrines of claim interpretation.

## Claims

1. A micro-LED comprising:
a mesa structure including a quantum well region disposed between an n-doped semiconductor layer and a p-doped semiconductor region, wherein the n-doped semiconductor layer forms a tapered semiconductor pre-waveguide that is narrowest at an interface with the quantum well region and/or is widest at a curved semiconductor exit surface of the tapered semiconductor pre-waveguide; and
a tapered dielectric waveguide having a lower refractive index than a higher refractive index of the tapered semiconductor pre-waveguide, wherein the tapered dielectric waveguide narrows as it approaches the tapered semiconductor pre-waveguide and/or is widest at a curved dielectric exit surface of the tapered dielectric waveguide.

2. The micro-LED of claim 1, wherein a top of the tapered semiconductor pre-waveguide is approximately spherical.

3. The micro-LED of claim 1 or 2, wherein a top of the tapered dielectric waveguide is approximately spherical.

4. The micro-LED of any preceding claim, further comprising:
a dielectric layer formed between the tapered dielectric waveguide and the tapered semiconductor pre-waveguide, wherein a middle refractive index of the dielectric layer is between the lower refractive index and the higher refractive index.

5. The micro-LED of any preceding claim, further comprising:
an oxide layer disposed around the tapered dielectric waveguide, wherein the oxide layer has an oxide refractive index that is lower than the lower refractive index of the tapered dielectric waveguide.

6. The micro-LED of claim 5, wherein the oxide layer contacts the tapered dielectric waveguide without contacting the tapered semiconductor pre-waveguide.

7. The micro-LED of claim 5 or 6, wherein a thin oxide layer of the oxide layer is disposed over a dielectric exit surface of the tapered dielectric waveguide.

8. The micro-LED of any preceding claim, wherein dielectric sidewalls of the tapered dielectric waveguide are configured to provide an emission cone angle of between 16 degrees to 20 degrees;
preferably wherein dielectric sidewalls of the tapered dielectric waveguide are disposed at a slant angle of between 10 degrees and 12 degrees with respect to an emission optical axis of the micro-LED.

9. The micro-LED of any preceding claim, wherein dielectric sidewalls of the tapered dielectric waveguide are disposed at a slant angle that is a continuation of semiconductor sidewalls of the tapered semiconductor pre-waveguide.

10. The micro-LED of any preceding claim, further comprising:
an oxide layer disposed around the mesa structure; and
a reflective layer disposed around the mesa structure, wherein the oxide layer is disposed between the reflective layer and the mesa structure.

11. The micro-LED of any preceding claim, further comprising:
an n-contact layer configured to electrically bias the n-doped semiconductor layer of the tapered semiconductor pre-waveguide, wherein the tapered semiconductor pre-waveguide includes a thin collar region disposed around the tapered semiconductor pre-waveguide below a semiconductor exit surface of the tapered semiconductor pre-waveguide,
and wherein the thin collar region contacts the n-contact layer;
preferably wherein the tapered dielectric waveguide contacts the n-contact layer and contacts the thin collar region.

12. The micro-LED of any preceding claim, wherein the tapered dielectric waveguide is formed of silicon nitride.

13. The micro-LED of any preceding claim, further comprising:
an anti-reflective, AR, layer formed between the tapered dielectric waveguide and the tapered semiconductor pre-waveguide, wherein a middle refractive index of the AR layer is between the lower refractive index and the higher refractive index.

14. A display including a display pixel array, wherein the display pixel array includes micro-LEDs according to any preceding claim.

15. A head mounted display, HMD, comprising:
a frame; and
a display pixel array configured to provide virtual images included in display light to an eyebox region of the HMD, wherein the display pixel array includes micro-LEDs according to any of claims 1 to 13.
